# EUROPEAN PATENT APPLICATION

(11) **EP 4 001 975 A1**
(43) Date of publication of application: **25.05.2022**
(21) Application number: 20839754.7
(22) Date of filing: 09.07.2020
(51) Int. Cl.: G02B 5/20, F21V 9/30

(54) **WAVELENGTH CONVERSION MEMBER FOR SOLDERING, WAVELENGTH CONVERSION DEVICE, AND LIGHT SOURCE DEVICE**

(30) Priority: 16.07.2019 JP 2019131118
(71) Applicant: NGK SPARK PLUG CO., LTD., Mizuho-ku Nagoya-shi, Aichi 467-8525 (JP)
(72) Inventor: YATSUYA Yosuke, Nagoya-shi, Aichi 467-8525 (JP); ARAKAWA Ryuichi, Nagoya-shi, Aichi 467-8525 (JP); SAKURAI Toshiyuki, Nagoya-shi, Aichi 467-8525 (JP); ITO Tsuneyuki, Nagoya-shi, Aichi 467-8525 (JP); TAKEUCHI Hiroki, Nagoya-shi, Aichi 467-8525 (JP); TANAKA Tomoo, Nagoya-shi, Aichi 467-8525 (JP); KATSU Yusuke, Nagoya-shi, Aichi 467-8525 (JP)
(74) Representative: J A Kemp LLP
(86) International application number: PCT/JP2020/026823
(87) International publication number: WO 2021/010273

(57) **Abstract**

A wavelength conversion member for soldering includes a ceramic fluorescent body for converting a wavelength of light entering from an incident surface of the ceramic fluorescent body, a reflection layer disposed on a back surface of the ceramic fluorescent body on a side opposite the incident surface and partially or entirely covering the back surface, and a junction layer composed of one or more films and covering at least the reflection layer selected from the back surface of the ceramic fluorescent body and the reflection layer. The junction layer has a projecting portion which projects, in relation to an outer circumferential portion of the junction layer, in a center portion of a surface on a side opposite a surface on a side where the junction layer covers at least the reflection layer selected from the back surface and the reflection layer.

## Description

### [Technical Field]

The present invention relates to a wavelength conversion member for soldering, to a wavelength conversion device, and to a light source device.

### [Background Art]

Heretofore, a wavelength conversion device for converting the wavelength of light emitted from a light source has been known. In general, the wavelength conversion device is composed of a fluorescent body for converting the wavelength of incoming light, a heat radiation member, and a solder layer for joining together the fluorescent body and the heat radiation member. Heat of the fluorescent body is radiated by the heat radiation member. Voids contained in solder lower thermal conductivity between the fluorescent body and the heat radiation member. For example, Patent Document 1 discloses a technique of reducing the sizes of voids contained in the solder layer to a prescribed value or smaller.

### [Prior Art Document]

### [Patent Document]

[Patent Document 1] Japanese Patent No. 6020631

### [Summary of the Invention]

### [Problem to be Solved by the Invention]

However, even in the case where the fluorescent body and the heat radiation member are joined together by the technique disclosed in Patent Document 1, voids remain between the fluorescent body and the heat radiation member, and therefore, further improvement of thermal conductivity of the solder layer has not been easy.

The present invention has been accomplished so as to solve the above-described problem, and an object of the present invention is to provide a technique for improving thermal conductivity between a heat radiation member and a ceramic fluorescent body in a wavelength conversion member for soldering.

### [Means for Solving the Problem]

The present invention has been accomplished so as to solve at least part of the above-described problem and can be realized in the following aspects.

(1) According to one aspect of the present invention, a wavelength conversion member for soldering is provided. This wavelength conversion member for soldering includes a ceramic fluorescent body for converting a wavelength of light entering from an incident surface of the ceramic fluorescent body; a reflection layer disposed on a back surface of the ceramic fluorescent body on a side opposite the incident surface and partially or entirely covering the back surface; and a junction layer composed of one or more films and covering at least the reflection layer selected from the back surface of the ceramic fluorescent body and the reflection layer, wherein the junction layer has a projecting portion which projects, in relation to an outer circumferential portion of the junction layer, in a center portion of a surface on a side opposite a surface on a side where the junction layer covers at least the reflection layer selected from the back surface and the reflection layer.
   According to this configuration, the junction layer has the projecting portion which projects, in relation to the outer circumferential portion, in a center portion of the surface on the side opposite the surface on the side where the junction layer covers the reflection layer. When the ceramic fluorescent body and a heat radiation member are soldered together via the junction layer, of solder disposed between the junction layer and the heat radiation member, a solder portion between the projecting portion and the heat radiation member is pushed out from the center toward the outside. At that time, voids contained in the solder between the projecting portion and the heat radiation member move, together with the solder, from a region between the projecting portion and the heat radiation member to a region between the outer circumferential portion and the heat radiation member. As a result, the number of the voids between the projecting portion and the heat radiation member decreases, thereby decreasing the degree of hindrance of heat conduction between the ceramic fluorescent body and the heat radiation member by the voids. Accordingly, the thermal conductivity between the ceramic fluorescent body and the heat radiation member can be improved.
(2) In the wavelength conversion member for soldering of the above-described aspect, the junction layer may be formed in such a manner that the junction layer directly covers both the reflection layer and an exposed portion of the back surface of the ceramic fluorescent body, and the projecting portion of the junction layer covers the reflection layer. According to this configuration, the reflection layer is formed to cover a portion of the back surface of the ceramic fluorescent body. Therefore, when the junction layer is formed on the exposed back surface of the ceramic fluorescent body and the reflection layer, the junction layer formed on the reflection layer projects in relation to the junction layer formed on the back surface of the ceramic fluorescent body. Namely, the projecting portion of the junction layer is formed on the reflection layer, and the outer circumferential portion of the junction layer is formed on the exposed back surface of the ceramic fluorescent body. Since the junction layer having the projecting portion and the outer circumferential portion can be formed by utilizing the shape of the reflection layer, the thermal conductivity between the ceramic fluorescent body and the heat radiation member can be enhanced easily.
(3) In the wavelength conversion member for soldering of the above-described aspect, the junction layer may include a junction film, and an adhesion film formed of chromium or titanium, disposed between the ceramic fluorescent body and the junction film, and adhering the ceramic fluorescent body and the junction film to each other. According to this configuration, the junction layer, which covers both the back surface of the ceramic fluorescent body and the reflection layer, includes the junction film for soldering the ceramic fluorescent body to, for example, the heat radiation member, and the adhesion film disposed between the ceramic fluorescent body and the junction film. Since the adhesion film enhances the adhesion between the ceramic fluorescent body and the junction film, the adhesion film can increase the strength of joining the ceramic fluorescent body and the heat radiation member by soldering. Therefore, a failure in joining the ceramic fluorescent body and the heat radiation member can be suppressed.
(4) In the wavelength conversion member for soldering of the above-described aspect, a film of the junction layer constituting the surface on the side opposite the surface on the side where the junction layer covers at least the reflection layer selected from the back surface and the reflection layer may contain, as a main component, at least one of nickel, palladium, platinum, molybdenum, and tungsten. According to this configuration, of the junction layer, the film constituting the surface on the side opposite the surface on the side where the junction layer covers the reflection layer contains, as a main component, at least one of nickel, palladium, platinum, molybdenum, and tungsten, which have relatively high melting points, are not easily oxidized, and are not easily nitrided. As a result, the film of the junction layer, which film constitutes the surface on the side opposite the surface on the side where the junction layer covers the reflection layer, is less likely to cause diffusion with gold. Therefore, the amount of the component of the junction layer migrating into the solder and forming a solid solution can be reduced, and thus, a failure in joining the ceramic fluorescent body and the heat radiation member can be suppressed.
(5) According to another aspect of the present invention, a wavelength conversion device is provided. This wavelength conversion device includes the above-described wavelength conversion member for soldering; a heat radiation member for radiating heat of the ceramic fluorescent body to an external atmosphere; and a solder layer provided between the junction layer and the heat radiation member and joining the wavelength conversion member for soldering to the heat radiation member, wherein the solder layer has a recessed portion surrounding the projecting portion of the junction layer. According to this configuration, when the ceramic fluorescent body and the heat radiation member are soldered together, the solder existing between the projecting portion and the heat radiation member and pushed outward from the center moves to the region between the outer circumferential portion of the junction layer and the heat radiation member and forms the recessed portion around the projecting portion. At that time, the voids contained in the solder between the projecting portion and the heat radiation member also move from the region between the projecting portion and the heat radiation member to the recessed portion. As a result, the number of the voids between the projecting portion and the heat radiation member decreases, thereby decreasing the degree of hindrance of heat conduction between the ceramic fluorescent body and the heat radiation member by the voids. Accordingly, the thermal conductivity between the ceramic fluorescent body and the heat radiation member can be improved.
(6) According to still another aspect of the present invention, a light source device is provided. This light source device includes the above-described wavelength conversion device; and a light source for applying light to the ceramic fluorescent body. According to this configuration, the light source device emits to the outside light whose wavelength differs from the wavelength of light which is applied to the ceramic fluorescent body by the light source. In the wavelength conversion device having the ceramic fluorescent body for converting the wavelength of the light, heat generated in the ceramic fluorescent body as a result of conversion of the wavelength of light is radiated to the outside from the heat radiation member through the solder. In the wavelength conversion device, the number of voids between the projecting portion and the heat radiation member is decreased because the junction layer has the projecting portion, and therefore, the heat of the ceramic fluorescent body can be easily conducted to the heat radiation member. Therefore, a decrease in the light emission intensity of the light source device due to temperature quenching can be suppressed.

Notably, the present invention can be realized in various forms. For example, the present invention can be realized in the form of, for example, a light emission system using the wavelength conversion member for soldering or the wavelength conversion device, a method for manufacturing the wavelength conversion member for soldering, the wavelength conversion device, or the light source device, a computer program for causing a computer to execute manufacture of the wavelength conversion member for soldering, the wavelength conversion device, or the light source device, a server apparatus which distributes the computer program, or a non-temporary storage medium storing the computer program.

### [Brief Description of the Drawings]

[Fig. 1] Cross-sectional view of a light source device including a wavelength conversion device of a first embodiment.
[Fig. 2] Cross-sectional view of a wavelength conversion member for soldering of the first embodiment.
[Fig. 3] Views used for describing a method for manufacturing the wavelength conversion device of the first embodiment.
[Fig. 4] Cross-sectional view of a light source device including a wavelength conversion device of a second embodiment.
[Fig. 5] Cross-sectional view of a wavelength conversion member for soldering of the second embodiment.
[Fig. 6] Cross-sectional view of a light source device including a wavelength conversion device of a third embodiment.
[Fig. 7] Cross-sectional view of a wavelength conversion member for soldering of the third embodiment.
[Fig. 8] Cross-sectional view of a light source device including a wavelength conversion device of a fourth embodiment.
[Fig. 9] Cross-sectional view of a wavelength conversion member for soldering of the fourth embodiment.

### [Mode for Carrying out the Invention]

### <First embodiment>

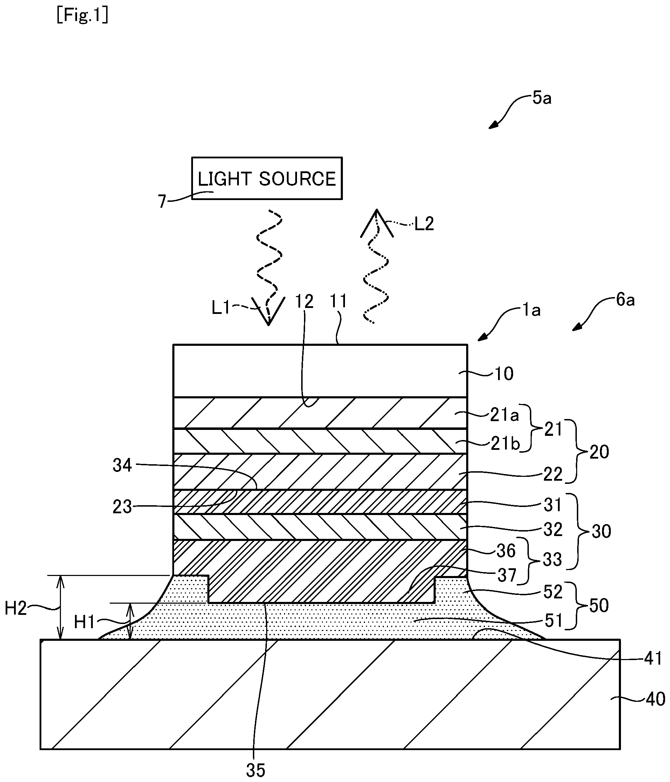

Fig. 1 is a cross-sectional view of a light source device 5a including a wavelength conversion device 6a of a first embodiment. The light source device 5a of the present embodiment includes a light source 7 and the wavelength conversion device 6a. When the wavelength conversion device 6a is irradiated with light L1 emitted from the light source 7, such as an externally provided light emitting diode (LED) or semiconductor laser (laser diode (LD)), the wavelength conversion device 6a emits light L2 having a wavelength different from that of the light L1. This wavelength conversion device 6a is used in various types of optical apparatuses such as headlights, lighting equipment, and projectors. The wavelength conversion device 6a includes a wavelength conversion member for soldering 1a, a heat radiation member 40, and a solder layer 50. Notably, in Fig. 1, for convenience of description, the wavelength conversion member for soldering 1a, the heat radiation member 40, and the solder layer 50 are illustrated in such a manner that the relation among their thicknesses differs from the actual relation among their thicknesses.

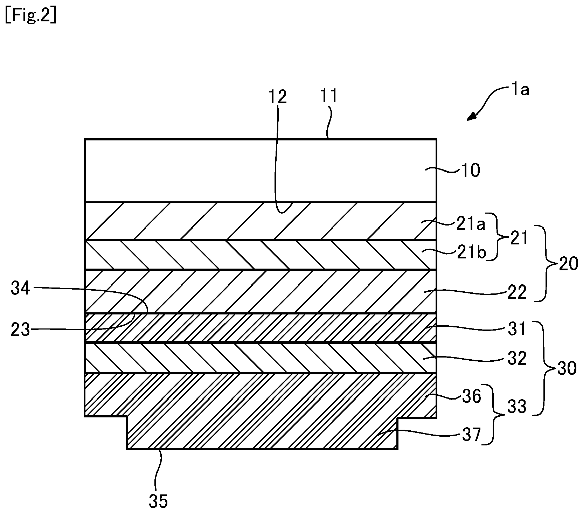

Fig. 2 is a cross-sectional view of the wavelength conversion member for soldering 1a of the first embodiment. The wavelength conversion member for soldering 1a includes a ceramic fluorescent body 10, a reflection layer 20, and a junction layer 30. The ceramic fluorescent body 10 is composed of a ceramic sintered body and converts the wavelength of light entering from an incident surface 11. The ceramic sintered body has a fluorescent phase mainly composed of fluorescent crystal grains and a translucent phase mainly composed of translucent crystal grains. Preferably, the crystal grains of the translucent phase have a composition represented by a chemical formula Al₂O₃, and the crystal grains of the fluorescent phase have a composition represented by a chemical formula A₃B₅O₁₂:Ce (so-called a garnet structure) . The formula "A₃B₅O₁₂:Ce" means that the element A of A₃B₅O₁₂ is partially substituted by Ce through formation of a solid solution.

The element A in the chemical formula A₃B₅O₁₂:Ce is at least one element selected from the following element group:

Sc, Y, and lanthanoids (except for Ce) (however, Gd may be further included in the element A).

The element B in the chemical formula A₃B₅O₁₂:Ce is at least one element selected from the following element group:
Al (however, Ga may be further included in the element B) .

Since a ceramic sintered body is used as the ceramic fluorescent body 10, light scatters at the interface between the fluorescent phase and the translucent phase, whereby the angle dependency of light color can be mitigated. As a result, the uniformity of color can be improved. Notably, the material of the ceramic fluorescent body 10 is not limited to the above-described material.

The reflection layer 20 is disposed on a back surface 12 of the ceramic fluorescent body 10 on the side opposite the incident surface 11 and is formed to cover the entire back surface 12. The reflection layer 20 includes a reflection increasing film 21 and a reflection film 22. In the reflection layer 20, the reflection increasing film 21 and the reflection film 22 are disposed in this order from the side where the ceramic fluorescent body 10 is present.

The reflection increasing film 21 includes a first layer 21a formed of titanium oxide (TiO₂) and a second layer 21b formed of silicon oxide (SiO₂). The reflection increasing film 21 reflects light within the ceramic fluorescent body 10 by the difference in refractive index between the first layer 21a and the second layer 21b. The reflection film 22 is formed of silver (Ag) or aluminum (Al) and reflects light propagating from the interior of the ceramic fluorescent body 10 through the reflection increasing film 21. Notably, the above-described configuration of the reflection layer 20 is an example, and the reflection layer 20 may be a single-layer film formed of, for example, aluminum, niobium oxide, titanium oxide, lanthanum oxide, tantalum oxide, yttrium oxide, gadolinium oxide, tungsten oxide, hafnium oxide, aluminum oxide, or silicon oxide, or may be a multi-layer film formed of materials different from the above-described materials.

The junction layer 30 is disposed on a lower surface 23 of the reflection layer 20 on the side opposite the ceramic fluorescent body 10 and is composed of one or more films covering the reflection layer 20. In the present embodiment, the junction layer 30 includes a protection film 31, an adhesion film 32, and a junction film 33. In the junction layer 30, the protection film 31, the adhesion film 32, and the junction film 33 are disposed in this order from the side where the ceramic fluorescent body 10 is present.

The protection film 31 is formed of aluminum oxide (Al₂O₃) and suppresses oxidation of the reflection film 22. The adhesion film 32 is formed of chromium (Cr) or titanium (Ti) and enhances the adhesion between the protection film 31 and the junction film 33. Notably, the materials used to form the protection film 31 and the adhesion film 32 are not limited thereto.

In the junction layer 30, the junction film 33 constitutes a surface 35 on the side opposite a surface 34 on the side where the junction layer 30 covers the reflection layer 20. The junction film 33 is formed of a material containing, as a main component, at least one of nickel (Ni), palladium (Pd), platinum (Pt), molybdenum (Mo), and tungsten (W). In the present embodiment, the junction film 33 contains nickel (Ni) as a main component. Here, the "main component" refers to a component contained in an amount of 50 at% or more as determined by EDS analysis. As shown in Fig. 2, the junction film 33 has a projecting portion 37 which projects, in relation to an outer circumferential portion 36, in a center portion of the surface 35 of the junction layer 30 on the side opposite the surface 34 on the side where the junction layer 30 covers the reflection layer 20. As a result, as shown in Fig. 2, the junction film 33 has a convex shape. Here, the convex shape refers to a state in which the junction film 33 has a portion where its thickness differs from other portions and is formed into a stepped shape. The junction film 33 reacts with solder and joins together the ceramic fluorescent body 10 and the solder.

The heat radiation member 40 is formed of a material whose thermal conductivity is higher than that of the ceramic fluorescent body 10, for example, copper, copper-molybdenum alloy, copper-tungsten alloy, aluminum, aluminum nitride, or the like. An unillustrated a metal film is disposed on a main surface 41 of the heat radiation member 40 on the side toward the ceramic fluorescent body 10. This metal film enhances the solder wettability of the heat radiation member 40. The heat radiation member 40 radiates, to an outside atmosphere, heat of the ceramic fluorescent body 10 conducted through the solder layer 50, etc. Notably, the heat radiation member 40 may be a member having a single-layer structure formed of the above-described material or may be a member having a multi-layer structure in which the layers are formed of the same material or different materials.

The solder layer 50 is provided between the junction layer 30 and the heat radiation member 40 and is formed of gold and tin. As shown in Fig. 1, the solder layer 50 has a central portion 51 between the projecting portion 37 of the junction film 33 and the heat radiation member 40, and a recessed portion 52 disposed on the outer side of the central portion 51 and surrounding the projecting portion 37 of the junction film 33. As shown in Fig. 1, the height H2 of the recessed portion 52 from the main surface 41 of the heat radiation member 40 is larger than the height H1 of the central portion 51 from the main surface 41. The solder layer 50 joins together the wavelength conversion member for soldering 1a and the heat radiation member 40.

Next, a method for manufacturing the wavelength conversion device 6a will be described. First, the reflection layer 20 and the junction layer 30 are formed in order on the ceramic fluorescent body 10 by means of vacuum deposition or sputtering. In formation of the junction film 33, a film having a thickness equal to the thickness of the projecting portion 37 is formed, and pattering is performed by means of photolithography, whereby the outer circumferential portion 36 and the projecting portion 37 are formed. Also, a metal film is formed on the heat radiation member 40 by means of plating. Subsequently, the ceramic fluorescent body 10 and the heat radiation member 40 with gold tin solder foil sandwiched between the junction film 33 of the ceramic fluorescent body 10 and the metal film of the heat radiation member 40 are heated in a reflow furnace in a nitrogen atmosphere or a hydrogen atmosphere so as to join together the ceramic fluorescent body 10 and the heat radiation member 40. Notably, in the case where a metal film is formed on the surface of the heat radiation member 40, the metal film may be formed by means of plating. Also, instead of using the gold tin solder foil, gold tin alloy paste may be used.

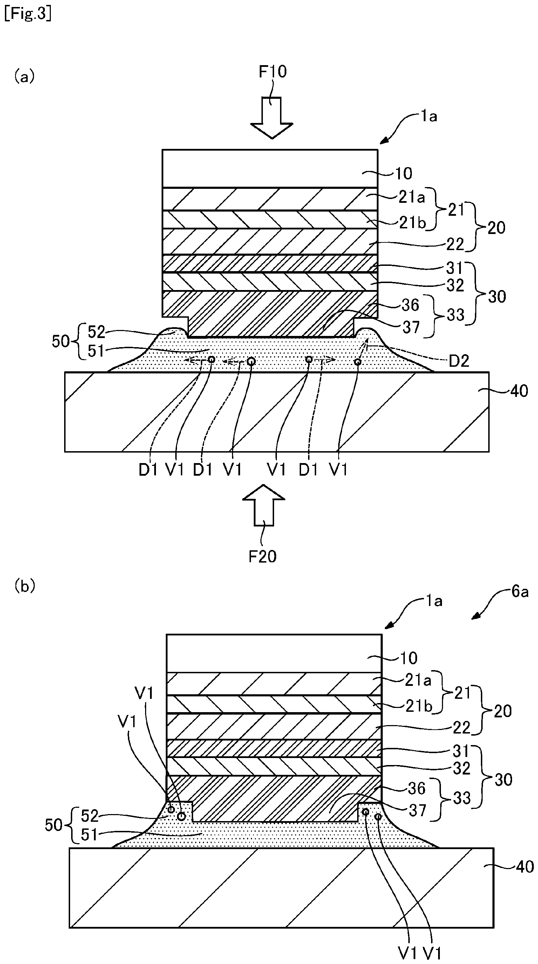

Fig. 3 is a pair of views used for describing the method of manufacturing the wavelength conversion device 6a. When the ceramic fluorescent body 10 and the heat radiation member 40 are joined together by means of heating in the reflow furnace, as shown in section (a) of Fig. 3, voids V1 originating from a gap between the two members are generated in gold tin paste which is to become the solder layer 50. When the ceramic fluorescent body 10 and the heat radiation member 40 are joined together by pressing them against each other (see outline arrows F10 and F20 shown in section (a) of Fig. 3), of the solder layer 50, a solder portion between the projecting portion 37 and the heat radiation member 40 is pushed out from the region between the projecting portion 37 and the heat radiation member 40, so that the solder portion protrudes toward the outside of the projecting portion 37. At that time, the voids V1 existing between the projecting portion 37 and the heat radiation member 40 are pushed out, together with the solder, from a region between the projecting portion 37 and the heat radiation member 40 toward the outside (broken line arrows D1 in section (a) of Fig. 3). The solder protruding to the outside of the projecting portion 37 rises between the outer circumferential portion 36 and the heat radiation member 40 and forms a recessed portion 52 which surrounds the projecting portion 37. At that time, the voids V1 move together with the solder rising between the outer circumferential portion 36 and the heat radiation member 40 (a broken line arrow D2 in section (a) of Fig. 3). In this manner, the voids V1 existing between the projecting portion 37 and the heat radiation member 40 move to the recessed portion 52. Therefore, in the manufacturing method of the present embodiment, as shown in section (b) of Fig. 3, the voids V1 of the solder layer 50 come together in the recessed portion 52, and the number of the voids V1 of the central portion 51 decreases. When the number of the voids V1 of the central portion 51 decreases, the degree of hindrance of thermal conduction in the central portion 51 between the ceramic fluorescent body 10 and the heat radiation member 40 by the voids V1 decreases.

According to the above-described wavelength conversion member for soldering 1a of the present embodiment, the junction layer 30 has the projecting portion 37 projecting, in relation to the outer circumferential portion 36, in a center portion of the surface 35 on the side opposite the surface 34 on the side where the junction layer 30 covers the reflection layer 20. When the ceramic fluorescent body 10 and the heat radiation member 40 are soldered together via the junction layer 30, of the solder disposed between the junction layer 30 and the heat radiation member 40, a solder portion between the projecting portion 37 and the heat radiation member 40 is pushed out from the center toward the outside. At that time, the voids V1 contained in the solder between the projecting portion 37 and the heat radiation member 40 move, together with the solder, from a region between the projecting portion 37 and the heat radiation member 40 to a region between the outer circumferential portion 36 and the heat radiation member 40. As a result, the number of the voids V1 between the projecting portion 37 and the heat radiation member 40 decreases, thereby decreasing the degree of hindrance of heat conduction between the ceramic fluorescent body 10 and the heat radiation member 40 by the voids V1. Accordingly, the thermal conductivity between the ceramic fluorescent body 10 and the heat radiation member 40 can be improved.

Also, according to the wavelength conversion member for soldering 1a of the present embodiment, of the junction layer 30, the junction film 33, which constitutes the surface 35 on the side opposite the surface 34 on the side where the junction layer 30 covers the reflection layer 20, is formed of a material containing nickel (Ni) as a main component. Therefore, when the wavelength conversion member for soldering 1a and the heat radiation member 40 are joined together by solder, diffusion of the component of the junction layer 30 from the junction layer 30 into the solder can be suppressed. Therefore, the amount of the component of the junction layer 30 migrating into the solder and forming a solid solution can be reduced, and thus, a failure in joining the ceramic fluorescent body 10 and the heat radiation member 40 can be suppressed.

Also, according to the wavelength conversion device 6a of the present embodiment, the solder layer 50 has the recessed portion 52 surrounding the projecting portion 37 of the junction layer 30. When the ceramic fluorescent body 10 and the heat radiation member 40 are soldered together, the solder existing between the projecting portion 37 and the heat radiation member 40 and pushed outward from the center moves to the region between the outer circumferential portion 36 of the junction layer 30 and the heat radiation member 40 and forms the recessed portion 52 around the projecting portion 37. At that time, the voids V1 contained in the solder between the projecting portion 37 and the heat radiation member 40 also move from the region between the projecting portion 37 and the heat radiation member 40 to the recessed portion 52, and therefore, the number of the voids V1 between the projecting portion 37 and the heat radiation member 40 decreases. As a result, the degree of hindrance of heat conduction between the ceramic fluorescent body 10 and the heat radiation member 40 by the voids V1 decreases, whereby the thermal conductivity between the ceramic fluorescent body 10 and the heat radiation member 40 can be improved.

Also, according to the light source device 5a of the present embodiment, the light source device 5a emits to the outside the light L2 whose wavelength differs from the wavelength of the light L1 which is applied to the ceramic fluorescent body 10 by the light source 7. In the wavelength conversion device 6a including the ceramic fluorescent body 10 for converting the wavelength of the light L1, heat generated as a result of conversion of the wavelength of the light L1 by the ceramic fluorescent body 10 is radiated to the outside atmosphere from the heat radiation member 40 through the solder. In the wavelength conversion device 6a, since the projecting portion 37 of the junction layer 30 decreases the number of the voids V1 between the projecting portion 37 and the heat radiation member 40, the heat of the ceramic fluorescent body 10 can be easily conducted to the heat radiation member 40. Therefore, a decrease in the light emission intensity of the light source device 5a due to temperature quenching can be suppressed.

### <Second embodiment>

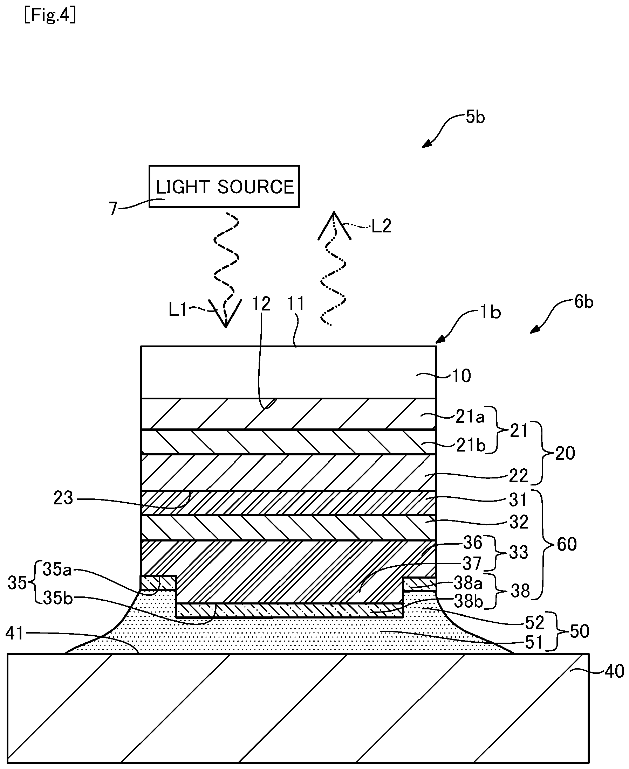

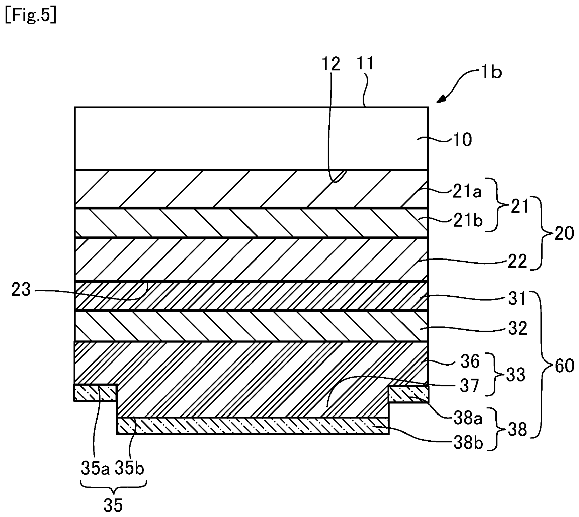

Fig. 4 is a cross-sectional view of a light source device 5b including a wavelength conversion device 6b of a second embodiment. Fig. 5 is a cross-sectional view of a wavelength conversion member for soldering 1b of the present embodiment. The wavelength conversion member for soldering 1b of the wavelength conversion device 6b of the present embodiment differs from the wavelength conversion member for soldering 1a of the first embodiment (Fig. 2) in the point that a junction layer 60 has a solder wetting film 38.

The wavelength conversion member for soldering 1b of the present embodiment includes the ceramic fluorescent body 10, the reflection layer 20, and the junction layer 60. The junction layer 60 is disposed on the lower surface 23 of the reflection layer 20 on the side opposite the ceramic fluorescent body 10 and is composed of one or more films covering the reflection layer 20. In the present embodiment, the junction layer 60 includes the protection film 31, the adhesion film 32, the junction film 33, and the solder wetting film 38.

The solder wetting film 38 is disposed to cover the surface 35 of the junction film 33 and is formed of gold. The solder wetting film 38 has an outer circumferential portion 38a and a projecting portion 38b. The outer circumferential portion 38a covers a surface 35a which is a portion of the surface 35 of the junction film 33 and is formed by the outer circumferential portion 36. The projecting portion 38b covers a surface 35b which is a portion of the surface 35 of the junction film 33 and is formed by the projecting portion 37. The thickness of the outer circumferential portion 38a is approximately the same as the thickness of the projecting portion 38b. The outer circumferential portion 38a and the projecting portion 38b improve the solder wettability of the ceramic fluorescent body 10.

Next, a method for manufacturing the wavelength conversion device 6b will be described. For manufacture of the wavelength conversion device 6b, first, the reflection layer 20 and the junction layer 60 are formed in order on the ceramic fluorescent body 10 by means of vacuum deposition or sputtering. At that time, by using photolithography, the junction film 33 having the outer circumferential portion 36 and the projecting portion 37 is formed by the same method as in the first embodiment, and the solder wetting film 38 is formed on the junction film 33. Subsequently, the ceramic fluorescent body 10 and the heat radiation member 40 with gold tin solder foil sandwiched between the solder wetting film 38 of the ceramic fluorescent body 10 and the metal film of the heat radiation member 40 are heated in a reflow furnace, whereby the ceramic fluorescent body 10 and the heat radiation member 40 are joined together.

According to the above-described wavelength conversion member for soldering 1b of the present embodiment, when the ceramic fluorescent body 10 and the heat radiation member 40 are soldered together via the junction layer 60, the voids contained in the solder between the projecting portion 38b and the heat radiation member 40 move, together with the solder, from a region between the projecting portion 38b and the heat radiation member 40 to a region between the outer circumferential portion 38a and the heat radiation member 40. As a result, the number of the voids between the projecting portion 38b and the heat radiation member 40 decreases, and therefore, the thermal conductivity between the ceramic fluorescent body 10 and the heat radiation member 40 can be improved.

Also, according to the wavelength conversion member for soldering 1b of the present embodiment, the junction layer 60 has the outer circumferential portion 38a and the projecting portion 38b which are good in solder wettability. Therefore, it becomes easier for the voids V1 contained in the solder between the projecting portion 38b and the heat radiation member 40 to move to the region between the outer circumferential portion 38a and the heat radiation member 40, and the number of the voids V1 between the projecting portion 38b and the heat radiation member 40 decreases further. Accordingly, the thermal conductivity between the ceramic fluorescent body 10 and the heat radiation member 40 can be further improved.

### <Third embodiment>

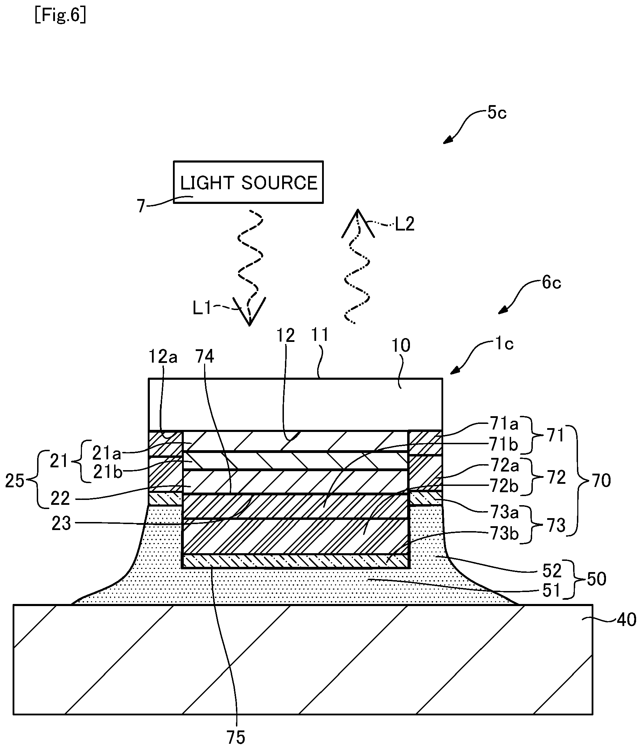

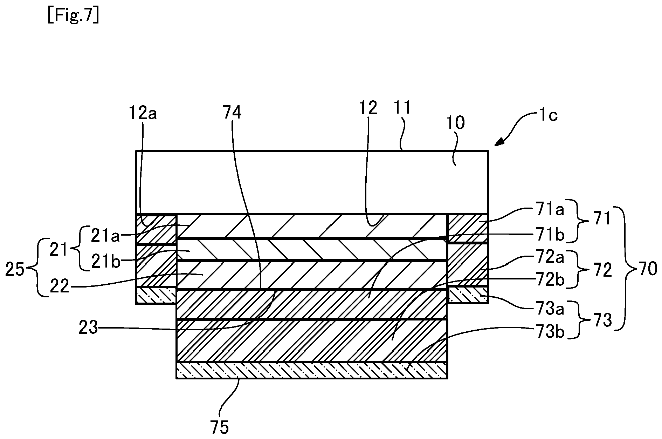

Fig. 6 is a cross-sectional view of a light source device 5c including a wavelength conversion device 6c of a third embodiment. Fig. 7 is a cross-sectional view of a wavelength conversion member for soldering 1c of the present embodiment. The wavelength conversion member for soldering 1c of the wavelength conversion device 6c of the present embodiment differs from the wavelength conversion member for soldering 1b of the second embodiment (Fig. 5) in the width of a reflection layer 25.

The wavelength conversion member for soldering 1c of the present embodiment includes the ceramic fluorescent body 10, the reflection layer 25, and a junction layer 70. As shown in Fig. 7, the width of the reflection layer 25 having the reflection increasing film 21 and the reflection film 22 is smaller than the width of the back surface 12 of the ceramic fluorescent body 10. The junction layer 70 is composed of one or more films directly covering both the reflection layer 25 and a back surface 12a which is an exposed portion of the back surface 12 of the ceramic fluorescent body 10. In the present embodiment, the junction layer 70 includes an adhesion film 71, a junction film 72, and a solder wetting film 73.

The adhesion film 71 is formed of chromium (Cr) or titanium (Ti). The adhesion film 71 has an outer circumferential portion 71a disposed on the exposed back surface 12a of the ceramic fluorescent body 10 and a projecting portion 71b disposed on the lower surface 23 of the reflection layer 25 on the side opposite the ceramic fluorescent body 10. In the present embodiment, the outer circumferential portion 71a and the projecting portion 71b are separated from each other. The thickness of the outer circumferential portion 71a is approximately the same as the thickness of the projecting portion 71b, and their thicknesses are not less than 10 nm and not greater than 500 nm. The adhesion film 71 enhances the adhesion between the reflection layer 25 and the junction film 72 and between the ceramic fluorescent body 10 and the junction film 72. In the present embodiment, the adhesion between the ceramic fluorescent body 10 and the junction film 72 can be enhanced further by setting the thickness of the adhesion film 71 to be not less than 10 nm and not greater than 500 nm. Notably, in the present embodiment, the thickness of the outer circumferential portion 71a and the thickness of the projecting portion 71b are approximately the same. However, the thickness of the outer circumferential portion 71a and the thickness of the projecting portion 71b may differ from each other.

The junction film 72 is formed of a material containing nickel (Ni) as a main component. The junction film 72 has an outer circumferential portion 72a covering the outer circumferential portion 71a of the adhesion film 71 and a projecting portion 72b covering the projecting portion 71b of the adhesion film 71. The outer circumferential portion 72a and the projecting portion 72b are separated from each other, and the thickness of the outer circumferential portion 72a is approximately the same as the thickness of the projecting portion 72b. The junction film 72 reacts with the solder wetting film 73 and joins together the ceramic fluorescent body 10 and the solder wetting film 73.

The solder wetting film 73 is formed of gold (Au) and has an outer circumferential portion 73a covering the outer circumferential portion 72a of the junction film 72 and a projecting portion 73b covering the projecting portion 72b of the junction film 72. The outer circumferential portion 73a and the projecting portion 73b are separated from each other, and the thickness of the outer circumferential portion 73a is approximately the same as the thickness of the projecting portion 73b. The solder wetting film 73 enhances the solder wettability of the ceramic fluorescent body 10.

As described above, in the present embodiment, the junction layer 70 has the projecting portions 71b, 72b, and 73b, which project in relation to the outer circumferential portions 71a, 72a, 73a in a center portion of a surface 75 on the side opposite a surface 74 on the side where the junction layer 70 directly covers both the back surface 12a of the ceramic fluorescent body 10 and the reflection layer 25. The projecting portions 71b, 72b, and 73b are formed to cover the reflection layer 25.

Next, a method for manufacturing the wavelength conversion device 6c will be described. For manufacture of the wavelength conversion device 6c, first, the reflection layer 25 and the junction layer 70 are formed in order on the ceramic fluorescent body 10 by means of vacuum deposition or sputtering. At that time, by using photolithography, the reflection layer 25 is formed to have a width smaller than the width of the back surface 12 of the ceramic fluorescent body 10. After formation of the reflection layer 25, the junction layer 70 is formed on the lower surface 23 of the reflection layer 25 on the side opposite the ceramic fluorescent body 10 and the back surface 12a of the ceramic fluorescent body 10 exposed around the reflection layer 25. Subsequently, the ceramic fluorescent body 10 and the heat radiation member 40 with gold tin solder foil sandwiched between the solder wetting film 73 of the ceramic fluorescent body 10 and the metal film of the heat radiation member 40 are heated in a reflow furnace, whereby the ceramic fluorescent body 10 and the heat radiation member 40 are joined together.

According to the above-described wavelength conversion member for soldering 1c of the present embodiment, when the ceramic fluorescent body 10 and the heat radiation member 40 are soldered together via the junction layer 70, the voids contained in the solder between the projecting portion 73b and the heat radiation member 40 move, together with the solder, from a region between the projecting portion 73b and the heat radiation member 40 to a region between the outer circumferential portion 73a and the heat radiation member 40. As a result, the number of the voids between the projecting portion 73b and the heat radiation member 40 decreases, and therefore, the thermal conductivity between the ceramic fluorescent body 10 and the heat radiation member 40 can be improved.

Also, according to the wavelength conversion member for soldering 1c of the present embodiment, the reflection layer 25 is formed to cover a portion of the back surface 12 of the ceramic fluorescent body 10. Therefore, when the junction layer 70 is formed on the exposed back surface 12a of the ceramic fluorescent body 10 and the reflection layer 25, the junction layer 70 formed on the reflection layer 25 projects in relation to the junction layer 70 formed on the back surface 12a of the ceramic fluorescent body 10. Namely, the projecting portions 71b, 72b, and 73b of the junction layer 70 are formed on the reflection layer 25, and the outer circumferential portions 71a, 72a, and 73a of the junction layer 70 are formed on the exposed back surface 12a of the ceramic fluorescent body 10. Since the junction layer 70 having the projecting portions 71b, 72b, and 73b and the outer circumferential portions 71a, 72a, and 73a can be formed by utilizing the shape of the reflection layer 25, the thermal conductivity between the ceramic fluorescent body 10 and the heat radiation member 40 can be enhanced easily.

Also, according to the wavelength conversion member for soldering 1c of the present embodiment, the junction layer 70, which covers both the back surface 12 of the ceramic fluorescent body 10 and the reflection layer 20, includes the junction film 72 for soldering the ceramic fluorescent body 10 to the heat radiation member 40, and the adhesion film 71 disposed between the ceramic fluorescent body 10 and the junction film 72. Since the adhesion film 71 enhances the adhesion between the ceramic fluorescent body 10 and the junction film 72, the adhesion film 71 can increase the strength of joining between the ceramic fluorescent body 10 and the heat radiation member 40 by soldering. Therefore, a failure in joining the ceramic fluorescent body 10 and the heat radiation member 40 can be suppressed.

### <Fourth embodiment>

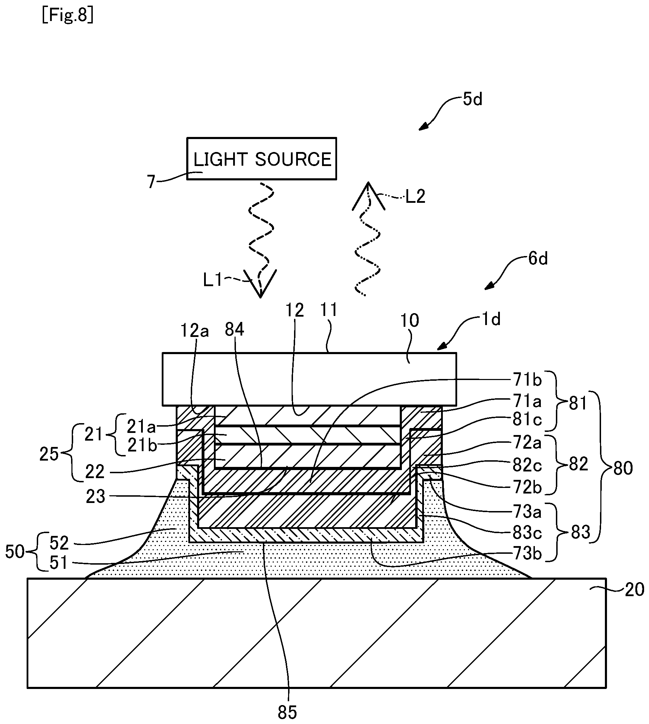

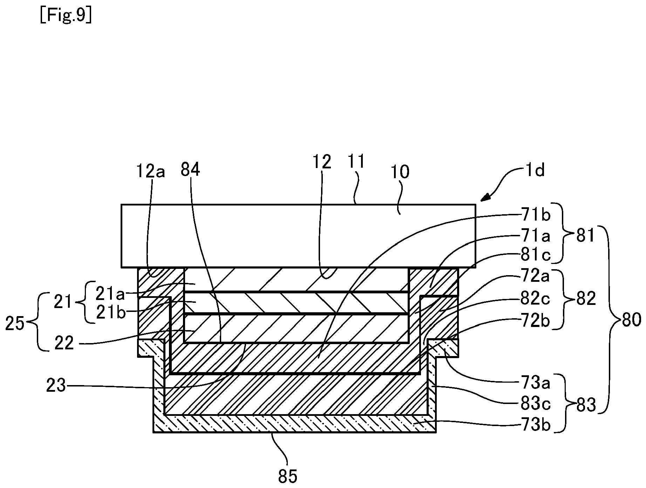

Fig. 8 is a cross-sectional view of a light source device 5d including a wavelength conversion device 6d of a fourth embodiment. Fig. 9 is a cross-sectional view of a wavelength conversion member for soldering 1d of the present embodiment. The wavelength conversion member for soldering 1d of the wavelength conversion device 6d of the present embodiment differs from the wavelength conversion member for soldering 1c of the third embodiment (Fig. 7) in the point that each of an adhesion film 81, a junction film 82, and a solder wetting film 83 has a projecting portion and an outer circumferential portion connected to each other.

The wavelength conversion member for soldering 1d of the present embodiment includes the ceramic fluorescent body 10, the reflection layer 25, and a junction layer 80. The junction layer 80 is composed of one or more films directly covering both the reflection layer 25 and the back surface 12a which is an exposed portion of the back surface 12 of the ceramic fluorescent body 10. In the present embodiment, the junction layer 80 includes the adhesion film 81, the junction film 82, and the solder wetting film 83.

The adhesion film 81 is formed of chromium (Cr) or titanium (Ti). In the present embodiment, the thickness of the adhesion film 81 is not less than 10 nm and not greater than 500 nm. The adhesion film 81 has the outer circumferential portion 71a, the projecting portion 71b, and a connecting portion 81c connecting the outer circumferential portion 71a and the projecting portion 71b on the side surface of the reflection layer 25. The adhesion film 81 enhances the adhesion between the reflection layer 25 and the junction film 82 and between the ceramic fluorescent body 10 and the junction film 82.

The junction film 82 is formed of a material containing nickel (Ni) as a main component. The junction film 82 has the outer circumferential portion 72a, the projecting portion 72b, and a connecting portion 82c formed to extend along the connecting portion 81c of the adhesion film 81 and connecting the outer circumferential portion 72a and the projecting portion 72b. The junction film 82 reacts with the solder wetting film 83 and joins together the ceramic fluorescent body 10 and the solder wetting film 83.

The solder wetting film 83 is formed of gold (Au) and has the outer circumferential portion 73a, the projecting portion 73b, and a connecting portion 83c formed to extend along the connecting portion 82c of the junction film 82 and connecting the outer circumferential portion 73a and the projecting portion 73b. The solder wetting film 83 enhances the solder wettability of the ceramic fluorescent body 10.

As described above, in the present embodiment, the junction layer 80 has the projecting portions 71b, 72b, and 73b, which project in relation to the outer circumferential portions 71a, 72a, and 73a in a center portion of a surface 85 on the side opposite a surface 84 on the side where the junction layer 80 directly covers both the back surface 12a of the ceramic fluorescent body 10 and the reflection layer 25. The projecting portions 71b, 72b, and 73b are formed to cover the reflection layer 25.

According to the above-described wavelength conversion member for soldering 1d of the present embodiment, when the ceramic fluorescent body 10 and the heat radiation member 40 are soldered together via the junction layer 80, the voids contained in the solder between the projecting portion 73b and the heat radiation member 40 move, together with the solder, from a region between the projecting portion 73b and the heat radiation member 40 to a region between the outer circumferential portion 73a and the heat radiation member 40. As a result, the number of the voids between the projecting portion 73b and the heat radiation member 40 decreases, and therefore, the thermal conductivity between the ceramic fluorescent body 10 and the heat radiation member 40 can be improved.

### <Modifications of the present embodiments>

The present invention is not limited to the above-described embodiments and can be practiced in various forms without departing from the gist of the invention, and, for example, the following modifications are possible.

### [Modification 1]

In the first, third, and fourth embodiments, the junction layer has three films. In the second embodiment, the junction layer has four films. However, the number of the films forming the junction layer is not limited thereto, and the junction layer may have one or two films or may have five or more films. In these cases, it is sufficient that the junction layer has the projecting portion which projects, in relation to the outer circumferential portion, in a center portion of the surface on the side opposite the surface on the side where the junction layer covers at least the reflection layer selected from the back surface 12 of the ceramic fluorescent body 10 and the reflection layer. By virtue of this configuration, when the ceramic fluorescent body 10 and the heat radiation member 40 are soldered together, the number of voids between the projecting portion and the heat radiation member 40 decreases, whereby the thermal conductivity between the ceramic fluorescent body 10 and the heat radiation member 40 can be enhanced.

### [Modification 2]

In the third and fourth embodiments, the projecting portion of the junction layer covers the reflection layer. However, the shape of the projecting portion is not limited thereto. The projecting portion and the outer circumferential portion may be formed in such a manner that the reflection layer is covered by the projecting portion and the outer circumferential portion. Alternatively, the outer circumferential portion may be formed on the outer side of the projecting portion formed to cover the reflection layer and the exposed back surface of the ceramic fluorescent body. In this case as well, when the ceramic fluorescent body 10 and the heat radiation member 40 are soldered together, the number of voids between the projecting portion and the heat radiation member 40 decreases, whereby the thermal conductivity between the ceramic fluorescent body 10 and the heat radiation member 40 can be enhanced.

### [Modification 3]

In the first embodiment, the junction film 33 is formed of a material containing nickel (Ni) as a main component. However, the composition of the junction film 33 in the first embodiment is not limited thereto. At least one of palladium, platinum, molybdenum, and tungsten may be used as the main component. In such a case, since the amount of the component of the junction layer 30 migrating into the solder and forming a solid solution can be reduced, the failure in joining the ceramic fluorescent body 10 and the heat radiation member 40 can be suppressed.

### [Modification 4]

In the above-described embodiments, the reflection layer has three films. However, the reflection layer may have only one film or may have two, four, or more films.

### [Modification 5]

In the junction layer, the projecting portion and the outer circumferential portion may connected to each other as in the first and second embodiments, the projecting portion and the outer circumferential portion may be separated from each other as in the third embodiment, or the projecting portion and the outer circumferential portion may be connected by the connecting portion as in the fourth embodiment.

### [Modification 6]

In the second, third, and fourth embodiments, the junction layer has a solder wetting film. However, the solder wetting film may be omitted.

Although the present aspects have been described on the basis of embodiments and modifications, the above-described embodiments of the aspects are provided so as to facilitate the understanding of the present aspects and do not limit the present aspects. The present aspects can be changed or improved without departing from the purpose of the aspects and the claims, and encompasses equivalents thereof. Also, the technical feature(s) may be eliminated as appropriate unless the present specification mentions that the technical feature(s) is mandatory.

### [Description of Symbols]

1a, 1b, 1c, 1d: wavelength conversion member for soldering
6a, 6b, 6c, 6d: wavelength conversion device
5a, 5b, 5c, 5d: light source device
7: light source
10: ceramic fluorescent body
11: incident surface
12, 12a: back surface
20, 25: reflection layer
21: reflection increasing film
22: reflection film
23: lower surface
30, 60, 70, 80: junction layer
31: protection film
32, 71, 81: adhesion film
33, 72, 82: junction film
34, 74, 84: surface of the junction layer on the side where the junction layer covers the reflection layer
35, 35a, 35b, 75, 85: surface of the junction layer on the side opposite the surface on the side where the junction layer covers the reflection layer
36, 38a, 71a, 72a, 73a: outer circumferential portion
37, 38b, 71b, 72b, 73b: projecting portion
38, 73, 83: solder wetting film
40: heat radiation member
41: main surface
50: solder layer
51: central portion
52: recessed portion
81c, 82c, 83c: connecting portion
L1, L2: light
V1: void

## Claims

1. A wavelength conversion member for soldering comprising:
a ceramic fluorescent body for converting a wavelength of light entering from an incident surface of the ceramic fluorescent body;
a reflection layer disposed on a back surface of the ceramic fluorescent body on a side opposite the incident surface and partially or entirely covering the back surface; and
a junction layer composed of one or more films and covering at least the reflection layer selected from the back surface of the ceramic fluorescent body and the reflection layer,
wherein the junction layer has a projecting portion which projects, in relation to an outer circumferential portion of the junction layer, in a center portion of a surface on a side opposite a surface on a side where the junction layer covers at least the reflection layer selected from the back surface and the reflection layer.

2. A wavelength conversion member for soldering according to claim 1, wherein
the junction layer directly covers both the reflection layer and an exposed portion of the back surface of the ceramic fluorescent body; and
the projecting portion of the junction layer covers the reflection layer.

3. A wavelength conversion member for soldering according to claim 2, wherein
the junction layer includes:
a junction film; and
an adhesion film formed of chromium or titanium, disposed between the ceramic fluorescent body and the junction film, and adhering the ceramic fluorescent body and the junction film to each other.

4. A wavelength conversion member for soldering according to any one of claims 1 to 3, wherein a film of the junction layer constituting the surface on the side opposite the surface on the side where the junction layer covers at least the reflection layer selected from the back surface and the reflection layer contains, as a main component, at least one of nickel, palladium, platinum, molybdenum, and tungsten.

5. A wavelength conversion device comprising:
a wavelength conversion member for soldering according to any one of claims 1 to 4;
a heat radiation member for radiating heat of the ceramic fluorescent body to an external atmosphere; and
a solder layer provided between the junction layer and the heat radiation member and joining the wavelength conversion member for soldering to the heat radiation member,
wherein the solder layer has a recessed portion surrounding the projecting portion of the junction layer.

6. A light source device comprising:
a wavelength conversion device according to claim 5; and
a light source for applying light to the ceramic fluorescent body.
